# EUROPEAN PATENT APPLICATION

(11) **EP 4 156 229 A1**
(43) Date of publication of application: **29.03.2023**
(21) Application number: 22195882.0
(22) Date of filing: 15.09.2022
(51) Int. Cl.: H01L 21/02, H01L 21/3115

(54) **METHOD OF PROCESSING SUBSTRATE, METHOD OF MANUFACTURING SEMICONDUCTOR DEVICE, SUBSTRATE PROCESSING SYSTEM, AND PROGRAM**

(30) Priority: 27.09.2021 JP 2021156751
(71) Applicant: Kokusai Electric Corp., Tokyo 1010045 (JP)
(72) Inventor: HARADA, Katsuyoshi, Toyama, 9392393 (JP); TERUI, Yusuke, Toyama, 9392393 (JP); HASHIMOTO, Yoshitomo, Toyama, 9392393 (JP)
(74) Representative: Bardehle Pagenberg Partnerschaft mbB Patentanwälte Rechtsanwälte

(57) **Abstract**

There is provided a technique that includes (a) forming a first film on the substrate by supplying a film-forming agent to the substrate; (b) adding oxygen to the first film by supplying a first oxidizing agent to the substrate and oxidizing a part of the first film; and (c) changing the oxygen-added first film into a second film including an oxide film by supplying a second oxidizing agent to the substrate and oxidizing the oxygen-added first film.

## Description

### CROSS-REFERENCE TO RELATED APPLICATION

This application is based upon and claims the benefit of priority from Japanese Patent Application No. 2021-156751, filed on September 27, 2021, the entire contents of which are incorporated herein by reference.

### TECHNICAL FIELD

The present disclosure relates to a method of processing a substrate, a method of manufacturing a semiconductor device, a substrate processing system, and a program.

### BACKGROUND

As a process of manufacturing a semiconductor device, a process of forming a nitride film on a substrate and oxidizing the nitride film into an oxide film is sometimes performed to form the oxide film on the substrate.

### SUMMARY

Some embodiments of the present disclosure provide a technique capable of improving the film quality of an oxide film formed on a substrate.

According to one embodiment of the present disclosure, there is provided a technique that includes (a) forming a first film on the substrate by supplying a film-forming agent to the substrate; (b) adding oxygen to the first film by supplying a first oxidizing agent to the substrate and oxidizing a part of the first film; and (c) changing the oxygen-added first film into a second film including an oxide film by supplying a second oxidizing agent to the substrate and oxidizing the oxygen-added first film.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in one embodiment of the present disclosure, in which the portion of the process furnace 202 is illustrated in a vertical sectional view.
FIG. 2 is a schematic configuration diagram of the vertical process furnace of the substrate processing apparatus suitably used in one embodiment of the present disclosure, in which the portion of the process furnace 202 is illustrated in a sectional view taken along line A-A in FIG. 1.
FIG. 3 is a schematic configuration diagram of a controller 121 of the substrate processing apparatus suitably used in one embodiment of the present disclosure, in which a control system of the controller 121 is illustrated in a block diagram.

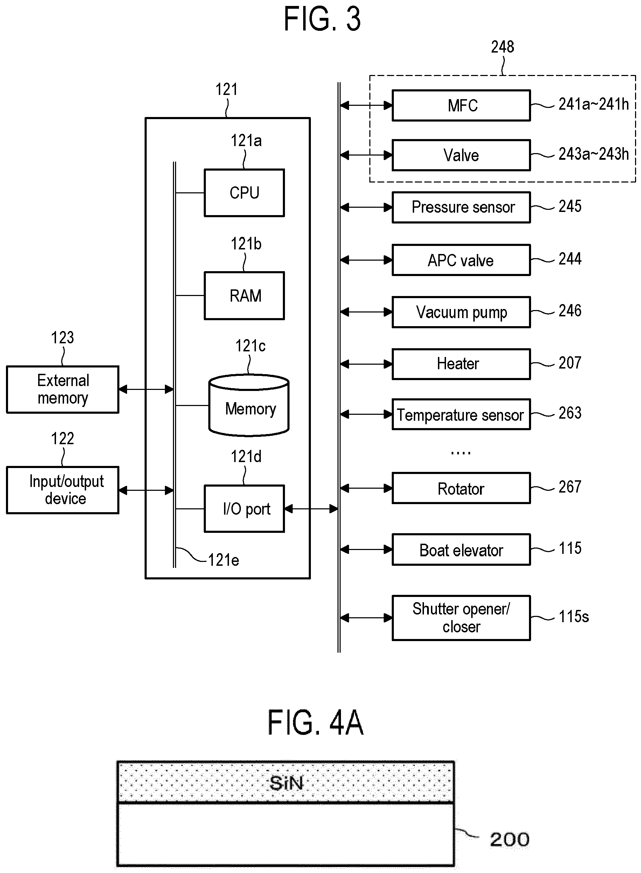

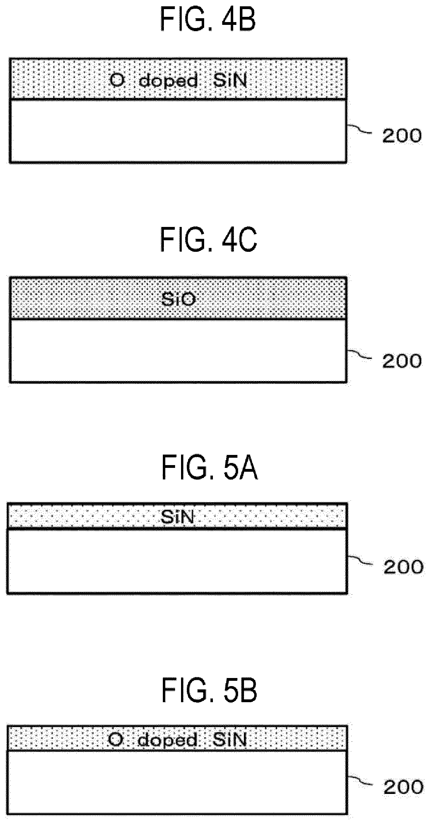

FIG. 4A is a partially enlarged sectional view of the surface of a wafer 200 after forming a silicon nitride film (SiN) as a first film on the wafer 200. FIG. 4B is a partially enlarged sectional view of the surface of the wafer 200 after oxidizing a portion of the silicon nitride film formed on the wafer 200 to change the silicon nitride film into an oxygen-added (doped) silicon nitride film (O-doped SiN film). FIG. 4C is a partially enlarged sectional view of the surface of the wafer 200 after oxidizing the oxygen-added silicon nitride film formed on the wafer 200 to change the oxygen-added silicon nitride film into a silicon oxide film (SiO) as a second film.

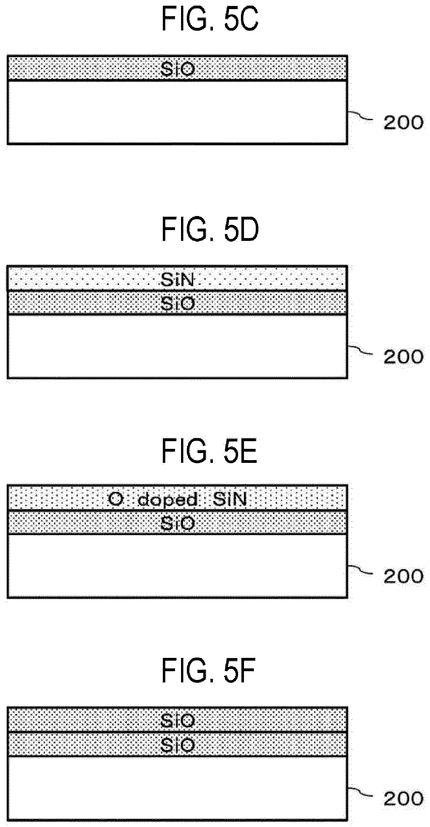

FIGS. 5A to 5C are identical to FIGS. 4A to 4C, respectively. FIG. 5D is a partially enlarged sectional view of the surface of the wafer 200 after forming a silicon nitride film (SiN) as a first film on the silicon oxide film (SiO) formed on the wafer 200. FIG. 5E is a partially enlarged sectional view of the surface of the wafer 200 after oxidizing a portion of the silicon nitride film formed on the silicon oxide film to change the silicon nitride film into an oxygen-added (doped) silicon nitride film (O-doped SiN film). FIG. 5F is a partially enlarged sectional view of the surface of the wafer 200 after oxidizing the oxygen-added silicon nitride film formed on the silicon oxide film to change the oxygen-added silicon nitride film into a silicon oxide film (SiO) as a second film.

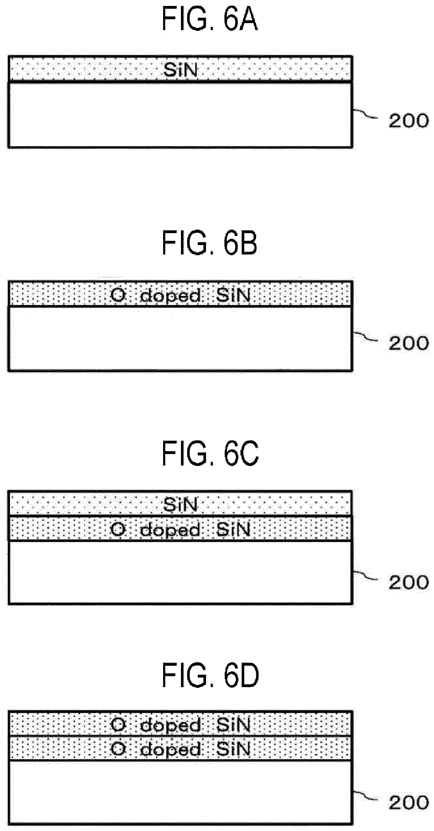

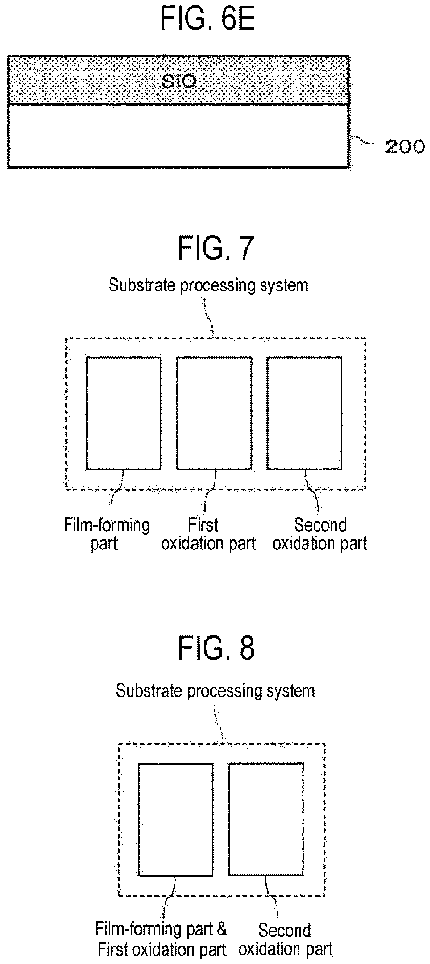

FIG. 6A is a partially enlarged sectional view of the surface of a wafer 200 after forming a silicon nitride film (SiN) as a first film on the wafer 200. FIG. 6B is a partially enlarged sectional view of the surface of the wafer 200 after oxidizing a portion of the silicon nitride film formed on the wafer 200 to change the silicon nitride film into an oxygen-added (doped) silicon nitride film (O-doped SiN film). FIG. 6C is a partially enlarged sectional view of the surface of the wafer 200 after forming a silicon nitride film (SiN) on the oxygen-added silicon nitride film (O-doped SiN film) formed on the wafer 200. FIG. 6D is a partially enlarged sectional view of the surface of the wafer 200 after oxidizing a portion of the silicon nitride film formed on the oxygen-added silicon nitride film (O-doped SiN film) to change the silicon nitride film into an oxygen-added silicon nitride film (O-doped SiN film). FIG. 6E is a partially enlarged sectional view of the surface of the wafer 200 after oxidizing the multilayer film of the oxygen-added silicon nitride films formed on the wafer 200 to change the multilayer film into a silicon oxide film (SiO) as a second film.
FIG. 7 is a block diagram for explaining an example of a substrate processing system preferably used in another aspect of the present disclosure.
FIG. 8 is a block diagram for explaining another example of a substrate processing system preferably used in a further aspect of the present disclosure.
FIG. 9 is a block diagram for explaining a further example of a substrate processing system preferably used in a still further aspect of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

### <One Embodiment of the Present Disclosure>

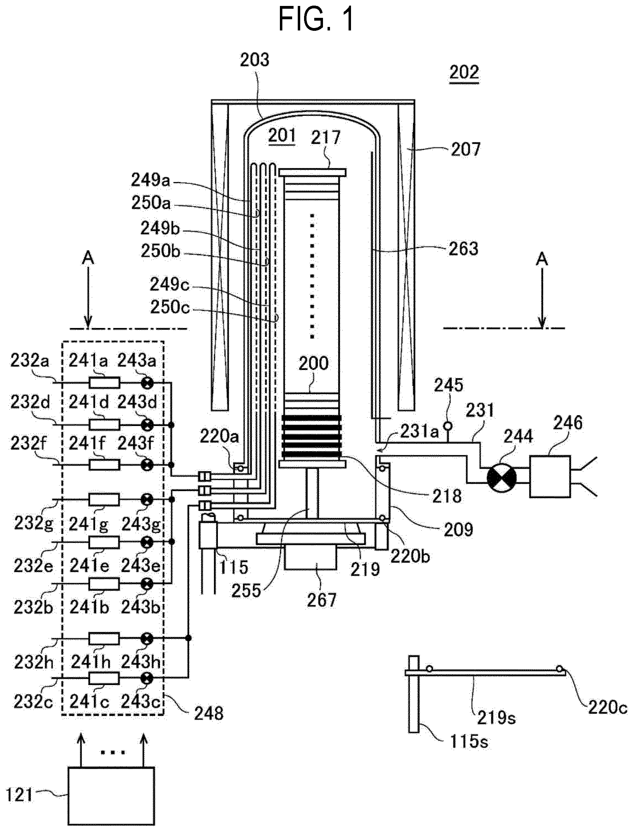

Hereinafter, one embodiment of the present disclosure will be described mainly with reference to FIGS. 1 to 3 and 4A to 4C. The drawings used in the following description are all schematic. The dimensional relationship of each element on the drawings, the ratio of each element, and the like do not always match the actual ones. Further, even between the drawings, the dimensional relationship of each element, the ratio of each element, and the like do not always match.

### (1) Configuration of Substrate Processing Apparatus

As shown in FIG. 1, a process furnace 202 includes a heater 207 as a temperature regulator (a heating part). The heater 207 has a cylindrical shape and is vertically installed by being supported by a hold. The heater 207 also functions as an activation mechanism (an excitation part) configured to thermally activate (excite) a gas.

Inside the heater 207, a reaction tube 203 is arranged concentrically with the heater 207. The reaction tube 203 is composed of a heat-resistant material such as, for example, quartz (SiO₂) or silicon carbide (SiC) or the like, and is formed in a cylindrical shape with an upper end thereof closed and a lower end thereof opened. Below the reaction tube 203, a manifold 209 is arranged concentrically with the reaction tube 203. The manifold 209 is composed of a metallic material such as, for example, stainless steel (SUS) or the like and is formed in a cylindrical shape with upper and lower ends thereof opened. The upper end portion of the manifold 209 is engaged with the lower end of the reaction tube 203 and is configured to support the reaction tube 203. An O-ring 220a as a seal member is installed between the manifold 209 and the reaction tube 203. Similar to the heater 207, the reaction tube 203 is installed vertically. A process container (reaction container) is mainly composed of the reaction tube 203 and the manifold 209. A process chamber 201 is formed in a hollow cylindrical portion of the process container. The process chamber 201 is configured to accommodate wafers 200 as substrates. The wafers 200 are processed in the process chamber 201.

Nozzles 249a to 249c as first to third supply parts are installed in the process chamber 201 so as to penetrate through a side wall of the manifold 209. The nozzles 249a to 249c are also referred to as first to third nozzles, respectively. The nozzles 249a to 249c are composed of, for example, a heat-resistant material such as quartz or SiC. Gas supply pipes 232a to 232c are connected to the nozzles 249a to 249c, respectively. The nozzles 249a to 249c are different nozzles, and the nozzles 249a and 249c are installed adjacent to the nozzle 249b.

On the gas supply pipes 232a to 232c, mass flow controllers (MFCs) 241a to 241c, which are flow rate controllers (flow rate control parts), and valves 243a to 243c, which are opening/closing valves, are respectively installed sequentially from the upstream side of a gas flow. Gas supply pipes 232d and 232f are connected to the gas supply pipe 232a on the downstream side of the valve 243a. Gas supply pipes 232e and 232g are connected to the gas supply pipe 232b on the downstream side of the valve 243b. A gas supply pipe 232h is connected to the gas supply pipe 232c on the downstream side of the valve 243c. On the gas supply pipes 232d to 232h, MFCs 241d to 241h and valves 243d to 243h are respectively installed sequentially from the upstream side of a gas flow. The gas supply pipes 232a to 232h are composed of, for example, a metal material such as stainless steel or the like.

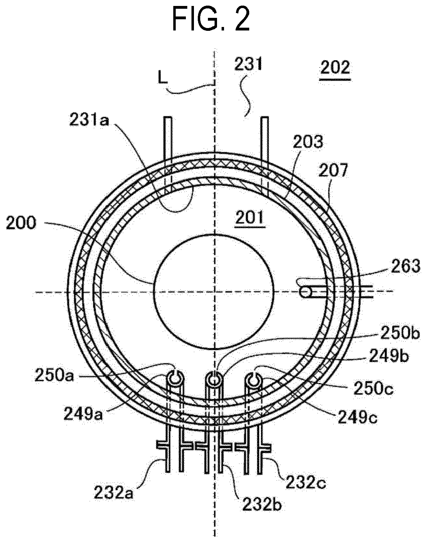

As shown in FIG. 2, the nozzles 249a to 249c are installed in an annular space (in a plan view) between an inner wall of the reaction tube 203 and the wafers 200 such that each of the nozzles 249a to 249c extends upward along an arrangement direction of the wafers 200 from a lower portion to an upper portion of the inner wall of the reaction tube 203. Specifically, the nozzles 249a to 249c are respectively installed in a region horizontally surrounding a wafer arrangement region, in which the wafers 200 are arranged, on a lateral side of the wafer arrangement region so as to extend along the wafer arrangement region. In a plan view, the nozzle 249b is disposed to face an exhaust port 231a to be described later, on a straight line across the centers of the wafers 200 loaded into the process chamber 201. The nozzles 249a and 249c are arranged so as to sandwich a straight line L passing through the nozzle 249b and the center of the exhaust port 231a from both sides along the inner wall of the reaction tube 203 (the outer peripheral portion of the wafers 200). The straight line L is also a straight line passing through the nozzle 249b and the center of the wafers 200. The nozzle 249c may installed on the side opposite to the nozzle 249a with the straight line L interposed therebetween. The nozzles 249a and 249c are arranged in line-symmetry with the straight line L as an axis of symmetry. Gas supply holes 250a to 250c for supplying gases are formed on a side surfaces of the nozzles 249a to 249c, respectively. The gas supply holes 250a to 250c are respectively opened so as to oppose (face) the exhaust port 231a in a plan view, which enables a gas to be supplied toward the wafers 200. A plurality of gas supply holes 250a to 250c are formed from the lower portion to the upper portion of the reaction tube 203.

From the gas supply pipe 232a, a precursor (precursor gas) is supplied into the process chamber 201 via the MFC 241a, the valve 243a and the nozzle 249a. The precursor is used as one of film-forming agents.

From the gas supply pipe 232b, a reactant (reaction gas) is supplied into the process chamber 201 via the MFC 241b, the valve 243b, and the nozzle 249b. The reactant is used as one of film-forming agents.

From the gas supply pipe 232c, a first oxidizing gas is supplied into the process chamber 201 via the MFC 241c, the valve 243c, and the nozzle 249c. The first oxidizing gas is used as a first oxidizing agent.

From the gas supply pipe 232d, a reducing gas is supplied into the process chamber 201 through the MFC 241d, the valve 243d, the gas supply pipe 232a, and the nozzle 249a. The reducing gas is used as one of second oxidizing agents.

From the gas supply pipe 232e, a second oxidizing gas is supplied into the process chamber 201 via the MFC 241e, the valve 243e, and the nozzle 249b. The second oxidizing gas is used as one of second oxidizing agents.

From the gas supply pipes 232f to 232h, an inert gas is supplied into the process chamber via the MFCs 241f to 241h, the valves 243f to 243h, the gas supply pipes 232a to 232c, and the nozzles 249a to 249c, respectively. The inert gas acts as a purge gas, a carrier gas, a diluting gas, and the like.

A precursor supply system (precursor gas supply system) mainly includes the gas supply pipe 232a, the MFC 241a and the valve 243a. A reactant supply system (reaction gas supply system) mainly includes the gas supply pipe 232b, the MFC241b and the valve 243b. A first oxidizing gas supply system mainly includes the gas supply pipe 232c, the MFC 241c and the valve 243c. A reducing gas supply system mainly includes the gas supply pipe 232d, the MFC 241d and the valve 243d. A second oxidizing gas supply system mainly includes the gas supply pipe 232e, the MFC 241e and the valve 243e. An inert gas supply system mainly includes the gas supply pipes 232f to 232h, the MFCs 241f to 241h and the valves 243f to 243h.

Each or all of the precursor supply system and the reactant supply system are also referred to as a film-forming agent supply system. The first oxidizing gas supply system is also called a first oxidizing agent supply system. Each or all of the second oxidizing gas supply system and the reducing gas supply system are also referred to as a second oxidizing agent supply system.

Among the various supply systems described above, any or all of the supply systems may be configured as an integrated supply system 248 in which the valves 243a to 243h, the MFCs 241a to 241h and the like are integrated. The integrated supply system 248 is connected to each of the gas supply pipes 232a to 232h and is configured so that the operation of supplying various materials (various gases) into the gas supply pipes 232a to 232h (i.e., the opening or closing operation of the valves 243a to 243h, the flow rate adjustment operation by the MFCs 241a to 241h, and the like) are controlled by a controller 121 described later. The integrated supply system 248 is configured as an integral type or division type integrated unit and may be attached to or detached from the gas supply pipes 232a to 232h on an integrated unit basis. The maintenance, replacement, expansion, and the like of the integrated supply system 248 may be performed on an integrated unit basis.

The exhaust port 231a for exhausting an internal atmosphere of the process chamber 201 is installed in the lower portion of the side wall of the reaction tube 203. As shown in FIG. 2, in a plan view, the exhaust port 231a is installed at a position facing the nozzles 249a to 249c (the gas supply holes 250a to 250c) with the wafers 200 interposed therebetween. The exhaust port 231a may be installed from the lower portion to the upper portion of the side wall of the reaction tube 203, i.e., along the wafer arrangement region. An exhaust pipe 231 is connected to the exhaust port 231a. A vacuum pump 246 as device vacuum exhauster is connected to the exhaust pipe 231 via a pressure sensor 245 as a pressure detector (pressure detection part) for detecting the pressure inside the process chamber 201 and an APC (Auto Pressure Controller) valve 244 as a pressure regulator (pressure regulation part). The APC valve 244 is configured to perform or stop a vacuum exhausting operation in the process chamber 201 by opening or closing the valve in a state in which the vacuum pump 246 is operated. Furthermore, the APC valve 244 is configured to regulate the pressure inside the process chamber 201 by adjusting an opening degree of the valve based on the pressure information detected by the pressure sensor 245 in a state in which the vacuum pump 246 is operated. An exhaust system mainly includes the exhaust pipe 231, the APC valve 244 and the pressure sensor 245. The vacuum pump 246 may be included in the exhaust system.

A seal cap 219 as a furnace opening lid capable of air-tightly closing a lower end opening of the manifold 209 is installed below the manifold 209. The seal cap 219 is composed of, for example, a metal material such as stainless steel or the like, and is formed in a disc shape. An O-ring 220b, which is a seal in contact with a lower end of the manifold 209, is installed on an upper surface of the seal cap 219 Below the seal cap 219, there is installed a rotator 267 configured to rotate a boat 217, which will be described later. A rotary shaft 255 of the rotator 267 is connected to the boat 217 through the seal cap 219. The rotator 267 is configured to rotate the wafers 200 by rotating the boat 217. The seal cap 219 is configured to be raised or lowered in the vertical direction by a boat elevator 115 as an elevator installed outside the reaction tube 203. The boat elevator 115 is configured as a transfer device (transfer mechanism) that loads or unloads (transfers) the wafers 200 into and out of the process chamber 201 by raising or lowering the seal cap 219.

Below the manifold 209, a shutter 219s is installed as a furnace opening lid capable of air-tightly closing the lower end opening of the manifold 209 in a state in which the seal cap 219 is lowered and the boat 217 is unloaded from the process chamber 201. The shutter 219s is composed of a metal material such as stainless steel or the like and is formed in a disk shape. An O-ring 220c, which is a seal in contact with the lower end of the manifold 209, is installed on an upper surface of the shutter 219s. The opening/closing operations (such as the elevating operation, the rotating operation, and the like) of the shutter 219s are controlled by a shutter opener/closer 115s.

The boat 217 as a substrate support is configured to support a plurality of wafers 200, for example, 25 to 200 wafers 200, in such a state that the wafers 200 are arranged in a horizontal posture and in multiple stages along vertical direction with the centers of the wafers 200 aligned with one another. That is, the boat 217 is configured to arrange the wafers 200 to be spaced apart from each other. The boat 217 is composed of a heat-resistant material such as quartz or SiC. Heat insulating plates 218 composed of a heat-resistant material such as quartz or SiC are supported in multiple stages at the bottom of the boat 217.

Inside the reaction tube 203, there is installed a temperature sensor 263 as a temperature detector. By adjusting a degree of conducting electricity of the heater 207 based on the temperature information detected by the temperature sensor 263, the temperature inside the process chamber 201 becomes a desired temperature distribution. The temperature sensor 263 is installed along the inner wall of the reaction tube 203.

As shown in FIG. 3, the controller 121 as a control part (control means) is configured as a computer including a CPU (Central Processing Unit) 121a, a RAM (Random Access Memory) 121b, a memory 121c and an I/O port 121d. The RAM 121b, the memory 121c and the I/O port 121d are configured to be capable of exchanging data with the CPU 121a via an internal bus 121e. An input/output device 122 configured as, for example, a touch panel or the like is connected to the controller 121. In addition, an external memory 123 can be connected to the controller 121.

The memory 121c is configured by, for example, a flash memory, a HDD (Hard Disk Drive), a SSD (Solid State Drive), or the like. In the memory 121c, there are readably stored a control program for controlling the operation of a substrate processing apparatus, a process recipe in which sequences and conditions of substrate processing to be described later are written. The process recipe is a combination that causes the controller 121 to have the substrate processing apparatus execute the respective procedures in the substrate processing, which will be described later, to obtain an expected result. The process recipe functions as a program. Hereinafter, the process recipe, the control program and the like are collectively and simply referred to as a "program." Furthermore, the process recipe may be simply referred to as a "recipe." When the term "program" is used herein, it may mean a case of including only the recipe, a case of including only the control program, or a case of including both the recipe and the control program. The RAM 121b is configured as a memory area (work area) in which programs, data and the like read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opener/closer 115s, and the like.

The CPU 121a is configured to read and execute the control program from the memory 121c and to read the recipe from the memory 121c in response to an input of an operation command from the input/output device 122 or the like. In addition, the CPU 121a is configured to be capable of control, according to the contents of the read recipe, the flow rate adjusting operation of various kinds materials (gases) by the MFCs 241a to 241h, the opening/closing operations of the valves 243a to 243h, the opening/closing operation of the APC valve 244, the pressure regulating operation by the APC valve 244 based on the pressure sensor 245, the actuating and stopping operation of the vacuum pump 246, the temperature regulating operation of the heater 207 based on the temperature sensor 263, the rotation and the rotation speed adjusting operation of the boat 217 by the rotator 267, the raising or lowering operation of the boat 217 by the boat elevator 115, the opening/closing operation of the shutter 219s by the shutter opener/closer 115s, and the like.

The controller 121 may be configured by installing, in the computer, the above-described program stored in an external memory 123. The external memory 123 includes, for example, a magnetic disc such as a HDD or the like, an optical disk such as a CD or the like, a magnetooptical disk such as a MO or the like, a semiconductor memory such as a USB memory, a SSD, or the like. The memory 121c or the external memory 123 are configured as a computer readable recording medium. Hereinafter, the memory 121c and the external memory 123 may be collectively and simply referred to as a "recording medium." As used herein, the term "recording medium" may include only the memory 121c, only the external memory 123, or both. Furthermore, the program may be provided to the computer using a communication means such as the Internet or a dedicated line, instead of using the external memory 123.

### (2) Substrate Processing Process

As a process of manufacturing a semiconductor device using the substrate processing apparatus described above, an example of a processing sequence in which an oxide film having a predetermined thickness is formed on a wafer 200 as a substrate will be described mainly with reference to FIGS. 4A to 4C. In the following description, the operation of each part constituting the substrate processing apparatus is controlled by the controller 121.

The processing sequence according to the present embodiment includes:
step A of forming a first film on a wafer 200 by supplying a precursor and a reactant as film-forming agents to the wafer 200;
step B of adding oxygen to the first film by supplying a first oxidizing gas as a first oxidizing agent to the wafer 200 and oxidizing a part of the film; and
step C of changing the oxygen-added first film into a second film including an oxide film by supplying a second oxidizing gas and a reducing gas as second oxidizing agents to the wafer 200 and oxidizing the oxygen-added first film.

In the processing sequence according to the present embodiment, in step A, step A1 of supplying the precursor to the wafer 200 and step A2 of supplying the reactant to the wafer 200 are alternately performed a predetermined number of times (m times where m is an integer of 1 or more). In step B, the first oxidizing gas is supplied to the wafer 200. In step C, the second oxidizing gas and the reducing gas are simultaneously supplied to the wafer 200.

Further, in step A, the first film containing a first element and a second element is formed. In step B, the first film is oxidized in an unsaturated manner to change the first film into the oxygen-added first film. In step C, the oxygen-added first film is oxidized in a saturated manner to change the oxygen-added first film into the second film containing the first element and oxygen. The first element includes, for example, silicon (Si), and the second element includes, for example, nitrogen (N). In the following, a case where the first element is Si and the second element is N will be described as a representative example.

In this specification, the above-described processing sequence may be denoted as follows for the sake of convenience. The same notation will be used in the following description of modifications and other embodiments.

(precursor → reactant) × m → first oxidizing gas → second oxidizing gas + reducing gas

The term "wafer" is used herein may refer to "a wafer itself" or "a wafer and a stacked body of certain layer or film formed on the surface of the wafer." The phrase "a surface of a wafer" used herein may refer to "a surface of a wafer itself" or "a surface of a certain layer formed on a wafer." The expression "a certain layer is formed on a wafer" used herein may mean that "a certain layer is directly formed on a surface of a wafer itself" or that "a certain layer is formed on a layer formed on a wafer." The term "substrate" used herein may be synonymous with the term "wafer."

As used herein, the term "agent" includes at least one of a gaseous substance and liquid substance. The liquid substance includes a misty substance. That is, the film-forming agents (precursor and reactant), the first oxidizing agent and the second oxidizing agents may include a gaseous substance, may include a liquid substance such as a misty substance or the like, or may include both of them.

As used herein, the term "layer" includes at least one of a continuous layer and a discontinuous layer. For example, the first layer and the second layer to be described later may include a continuous layer, may include a discontinuous layer, or may include both of them.

### (Wafer Charging and Boat Loading)

After a plurality of wafers 200 is charged to the boat 217 (wafer charging), the shutter 219s is moved by the shutter opener/closer 115s and the lower end opening of the manifold 209 is opened (shutter open). Thereafter, as shown in FIG. 1, the boat 217 charged with the plurality of wafers 200 is lifted by the boat elevator 115 and loaded into the process chamber 201 (boat loading). In this state, the seal cap 219 seals the lower end of the manifold 209 via the O-ring 220b. Thus, the wafers 200 are prepared inside the process chamber 201.

### (Pressure Regulation and Temperature Adjustment)

After the boat loading is finished, the inside of the process chamber 201, i.e., the space where the wafer 200 exists, is vacuum-exhausted (decompression-exhausted) by the vacuum pump 246 so that the pressure inside the process chamber 201 becomes a desired pressure (vacuum degree). At this time, the pressure inside the process chamber 201 is measured by the pressure sensor 245, and the APC valve 244 is subjected to feedback-controlled based on the measured pressure information. Furthermore, the wafer 200 in the process chamber 201 is heated by the heater 207 so that the wafer 200 is set to a desired temperature. At this time, the degree of conducting electricity of the heater 207 is feedback-controlled based on the temperature information detected by the temperature sensor 263 so that the inside of the process chamber 201 set to a desired temperature distribution. Moreover, the rotation of the wafer 200 by the rotator 267 is started. The exhaust of the process chamber 201 and the heating and rotation of the wafer 200 are continuously performed at least until the processing on the wafer 200 is finished.

### (Step A)

Thereafter, the following steps A1 and A2 are performed sequentially.

### [Step A1]

In step A1, a precursor (precursor gas) is supplied as a film-forming agent to the wafer 200 in the process chamber 201.

Specifically, the valve 243a is opened to allow the precursor to flow into the gas supply pipe 232a. The flow rate of the precursor flowing through the gas supply pipe 232a is adjusted by the MFC 241a. The precursor is supplied into the process chamber 201 through the nozzle 249a and is exhausted through the exhaust port 231a. At this time, the precursor is supplied to the wafer 200 from the lateral side of the wafer 200 (precursor supply). At this time, the valves 243f to 243h may be opened to supply an inert gas into the process chamber 201 through the nozzles 249a to 249c, respectively.

Processing conditions when supplying the precursor in step A1 are exemplified as follows.
Processing temperature: 250 to 500 degrees C, preferably 350 to 450 degrees C
Processing pressure: 10 to 1333 Pa, preferably 10 to 400 Pa
Precursor supply flow rate: 0.1 to 3 slm, preferably 0.1 to 0.5 slm
Precursor supply time: 1 to 180 seconds, preferably 10 to 30 seconds
Inert gas supply flow rate (in each gas supply pipe): 0 to 20 slm

In the present disclosure, the expression of a numerical range such as "250 to 500 degrees C" means that the lower limit and the upper limit are included in the range. Therefore, for example, "250 to 500 degrees C" means "250 degrees C or more and 500 degrees C or less". The same applies to other numerical ranges. Further, in the present disclosure, the term processing temperature means the temperature of the wafer 200 or the temperature inside the process chamber 201, and the term processing pressure means the pressure inside the process chamber 201. Moreover, the term processing time means the time during which the processing is continued. In addition, when 0 slm is included in the supply flow rate, the term 0 slm means a case where the substance (gas) is not supplied. These also apply to the following description.

By supplying, for example, a chlorosilane-based gas as a precursor to the wafer 200 under the above processing conditions, a Si-containing layer containing Cl is formed on the outermost surface of the wafer 200 as a base. The Si-containing layer containing Cl is formed on the outermost surface of the wafer 200 by physical adsorption or chemical adsorption of the precursor, chemical adsorption of a substance generated by the partial decomposition of the precursor, deposition of Si by the thermal decomposition of the precursor, or the like. The Si-containing layer containing Cl may be an adsorption layer (physisorption layer or chemisorption layer) of the precursor or a substance generated by the partial decomposition of the precursor, or may be a deposited layer of Si containing Cl. In this specification, the Si-containing layer containing Cl is also simply referred to as Si-containing layer.

After the Si-containing layer is formed, the valve 243a is closed to stop the supply of the precursor into the process chamber 201. Then, the inside of the process chamber 201 is vacuum-exhausted to remove gases and the like remaining in the process chamber 201 from the inside of the process chamber 201 (purge). At this time, the valves 243 f to 243 h are opened to supply an inert gas into the process chamber 201. The inert gas acts as a purge gas.

As the precursor (precursor gas) which is one of the film-forming agents, for example, a silane-based gas containing Si as a first element which is a main element constituting the film formed on the wafer 200 may be used. As the silane-based gas, for example, a gas containing Si as a first element and a halogen element, that is, a halosilane-based gas may be used. Halogen includes chlorine (Cl), fluorine (F), bromine (Br), iodine (I), and the like. As the halosilane-based gas, for example, a chlorosilane-based gas containing Si and Cl may be used.

Examples of the precursor may include: a chlorosilane-based gas such as monochlorosilane (SiH3Cl, abbreviation: MCS) gas, dichlorosilane (SiH₂Cl₂, abbreviation: DCS) gas, trichlorosilane (SiHCl₃, abbreviation: TCS) gas, tetrachlorosilane (SiCl₄, abbreviation: STC) gas, hexachlorodisilane (Si₂Cl₆, abbreviation: HCDS) gas, octachlorotrisilane (Si₃Cl₈, abbreviation: OCTS) gas or the like; a fluorosilane-based gas such as tetrafluorosilane (SiF₄) gas, difluorosilane (SiH₂F₂) gas or the like; bromosilane-based gas such as tetrabromosilane (SiBr₄) gas, dibromosilane (SiH₂Br₂) gas or the like; and an iodosilane-based gas such as tetraiodosilane (SiI₄) gas, diiodosilane (SiH₂I₂) gas or the like. Further, examples of the precursor may include: an alkylene chlorosilane-based gas such as bis(trichlorosilyl)methane ((SiCl₃)₂CH₂, abbreviation: BTCSM) gas, 1,2-bis(trichlorosilyl)ethane ((SiCl₃)₂C₂H₄, abbreviation: BTCSE) gas or the like; an alkyl chlorosilane-based gas such as 1,1,2,2-tetrachloro-1,2-dimethyldisilane ((CH₃)₂Si₂Cl₄, abbreviation: TCDMDS) gas, 1,2-dichloro-1,1,2,2-tetramethyldisilane ((CH₃)₄Si₂Cl₂, abbreviation: DCTMDS) gas or the like; and a gas having cyclic structure composed of Si and C and containing a halogen, such as 1,1,3,3-tetrachloro-1,3-disilacyclobutane (C₂H₄Cl₄Si₂, abbreviation: TCDSCB) gas or the like. One or more of these gases may be used as the precursor. When the silane-based gas containing carbon (C) such as the alkylene chlorosilane-based gas or the alkyl chlorosilane-based gas is used, a Si-containing layer containing C can be formed in step A1, and a SiN layer containing C can be formed in step A2 to be described later.

As the precursor (precursor gas), in addition to these gases, for example, a gas containing Si as a first element and an amino group, that is, an aminosilane-based gas may also be used. The amino group is a monovalent functional group obtained by removing hydrogen (H) from ammonia, primary amine, or secondary amine, and can be expressed as -NH₂, -NHR, or -NR₂. R indicates an alkyl group, and two R's in -NR₂ may be the same or different.

Examples of the precursor may include an aminosilane-based gas such as tetrakis(dimethylamino)silane (Si[N(CH₃)₂]₄, abbreviation: 4DMAS) gas, tris(dimethylamino)silane (Si[N(CH₃)₂]₃H, abbreviation: 3DMAS) gas, bis(diethylamino)silane (Si[N(C₂H₅)₂]₂H₂, abbreviation: BDEAS) gas, bis(tert-butylamino)silane (SiH₂[NH(C₄H₉)]₂, abbreviation: BTBAS) gas, (diisopropylamino)silane (SiH₃[N(C₃H₇)₂], abbreviation: DIPAS) gas or the like. One or more of these gases may be used as the precursor.

As the inert gas, for example, a rare gas such as nitrogen (N₂) gas, argon (Ar) gas, helium (He) gas, neon (Ne) gas, xenon (Xe) gas or the like may be used. As the inert gas, one or more of these gases may be used. This point is the same in each step described later.

### [Step A2]

After step A1 is finished, a reactant (reaction gas) is supplied as a film-forming agent to the wafer 200 in the process chamber 201, i.e., the Si-containing layer formed on the wafer 200.

Specifically, the valve 243b is opened to allow the reactant to flow into the gas supply pipe 232b. The flow rate of the reactant flowing through the gas supply pipe 232b is adjusted by the MFC 241b. The reactant is supplied into the process chamber 201 through the nozzle 249b, and is exhausted through the exhaust port 231a. At this time, the reactant is supplied to the wafer 200 from the lateral side of the wafer 200 (reactant supply). At this time, the valves 243f to 243h may be opened to supply an inert gas into the process chamber 201 through the nozzles 249a to 249c, respectively.

Processing conditions when supplying the reactant in step A2 are exemplified as follows.
Processing temperature: 250 to 500 degrees C, preferably 350 to 450 degrees C
Processing pressure: 10 to 2666 Pa, preferably 10 to 1333 Pa
Reactant supply flow rate: 1 to 10 slm, preferably 3 to 6 slm
Reactant supply time: 1 to 180 seconds, preferably 10 to 60 seconds
Inert gas supply flow rate (in each gas supply pipe): 0 to 20 slm

At least a part of the Si-containing layer formed on the wafer 200 is nitrided (modified) by supplying, for example, a hydrogen-nitride-based gas as a reactant to the wafer 200 under the above processing conditions. As a result, a silicon nitride layer (SiN layer) is formed as a layer containing Si and N on the outermost surface of wafer 200 as a base. When the SiN layer is formed, in the process of the modifying reaction of the Si-containing layer by the reactant, impurities such as Cl and the like contained in the Si-containing layer form a gaseous substance containing at least Cl, and are discharged from the inside of the process chamber 201. As a result, the SiN layer becomes a layer containing fewer impurities such as Cl and the like than the Si-containing layer formed in step A1.

After the SiN layer is formed, the valve 243b is closed to stop the supply of the reactant into the process chamber 201. Then, the gases and the like remaining in the process chamber 201 are removed from the process chamber 201 by the same processing procedure as the purge in step A1 (purge).

As the reactant (reaction gas), which is one of the film-forming agents, for example, an N-containing gas containing N as a second element and acting as a nitriding agent (nitriding gas) may be used. An N- and H-containing gas may be used as the N-containing gas. Examples of the N- and H-containing gas may include a hydrogen-nitride-based gas such as ammonia (NH₃) gas, diazene (N₂H₂) gas, hydrazine (N₂H₄) gas, N₃H₈ gas or the like may be used. As the N- and H-containing gas, for example, a C-, N- and H-containing gas may be used. Examples of the C-, N- and H-containing gas may include: an ethylamine-based gas such as monoethylamine (C₂H₅NH₂, abbreviation: MEA) gas, diethylamine ((C₂H₅)₂NH, abbreviation: DEA) gas, triethylamine ((C₂H₅)₃N, abbreviation: TEA) gas or the like; a methylamine-based gas such as monomethylamine (CH₃NH₂, abbreviation: MMA) gas, dimethylamine ((CH₃)₂NH, abbreviation: DMA) gas, trimethylamine ((CH₃)₃N, abbreviation: TMA) gas or the like; and an organic hydrazine-based gas such as monomethylhydrazine ((CH₃)HN₂H₂, abbreviation: MMH) gas, dimethylhydrazine ((CH₃)₂N₂H₂, abbreviation: DMH) gas, trimethylhydrazine ((CH₃)₂N₂(CH₃)H, abbreviation: TMH) gas or the like. One or more of these gases may be used as the reactant. When using the reactant containing C such as the amine-based gas or the organic hydrazine-based gas, a SiN layer containing C can be formed in step A2.

### [Performing a Predetermined Number of Times]

By performing a cycle a predetermined number of times (m times where m is an integer of 1 or more), the cycle including steps A1 and A2 described above, specifically, a cycle in which steps A1 and A2 described above are performed non-simultaneously, i.e., alternately without synchronization, a SiN film can be formed as a first film on the surface of the wafer 200 as a base, as shown in FIG. 4A. The above cycle is preferably repeated multiple times. That is, the thickness of the SiN layer formed per cycle is set to be thinner than a desired film thickness, and the above-mentioned cycle is repeated multiple times until the thickness of the SiN film formed by stacking the SiN layers reaches the desired thickness. The SiN film as the first film preferably contains H derived from the reactant in the form of N-H bonds. That is, the SiN film as the first film preferably contains N-H bonds in addition to Si-N bonds. This makes it possible to efficiently cause the reactions in steps B and C, which will be described later.

If the processing temperature in step A is less than 250 degrees C, it may become difficult to form the SiN film as the first film. By setting the processing temperature to 250 degrees C or higher, it becomes possible to form the SiN film as the first film, and it is possible to obtain a sufficient deposition rate. By setting the processing temperature to 350 degrees C or higher, a practical deposition rate can be obtained when forming the SiN film.

In addition, if the processing temperature in step A exceeds 500 degrees C, it may affect the film and structure existing on the surface of the wafer 200 when performing step A. Especially, this may not be permitted in the state-of-the-art devices with temperature restrictions. By setting the processing temperature to 500 degrees C or less, it is possible to suppress this effect. By setting the processing temperature to 450 degrees C or lower, it is possible to sufficiently suppress this effect.

### (Step B)

After step A is finished, a first oxidizing gas is supplied as a first oxidizing agent to the wafer 200 in the process chamber 201, i.e., the SiN film formed on the wafer 200.

Specifically, the valve 243c is opened to allow the first oxidizing gas to flow into the gas supply pipe 232c. The flow rate of the first oxidizing gas that has flowed through the gas supply pipe 232c is adjusted by the MFC 241c. The first oxidizing gas is supplied into the process chamber 201 through the nozzle 249c, and is exhausted through the exhaust port 231a. At this time, the first oxidizing gas is supplied to the wafer 200 from the lateral side of the wafer 200 (first oxidizing gas supply). At this time, the valves 243f to 243h may be opened to supply an inert gas into the process chamber 201 through the nozzles 249a to 249c, respectively.

Processing conditions when supplying the first oxidizing gas in step B are exemplified as follows.
Processing temperature: room temperature (25 degrees C) to 500 degrees C, preferably 350 to 450 degrees C
Processing pressure: 10 to 101,325 Pa, preferably 10 to 80,000 Pa
First oxidizing gas supply flow rate: 0.01 to 10 slm, preferably 0.5 to 3 slm
First oxidizing gas supply time: 60 seconds to 20 hours, preferably 60 seconds to 12 hours
Inert gas supply flow rate (in each gas supply pipe): 0 to 20 slm

By supplying the first oxidizing gas to the wafer 200 under the processing conditions described above, the SiN film as the first film formed on the wafer 200 is partially oxidized and oxygen (O) can be added (dope) to the SiN film. That is, the SiN film can be oxidized in an unsaturated manner to draw O into the SiN film. Thus, as shown in FIG. 4B, the SiN film formed on the wafer 200 in step A can be changed to an O-added SiN film (O-doped SiN film). In order to oxidize the SiN film in an unsaturated manner, the oxidation of a part of the SiN film by the first oxidizing agent (first oxidizing gas) in step B is preferably performed under a lower oxidizing power condition than the oxidation of the O-added SiN film in step C by the second oxidizing agents (the second oxidizing gas and the reducing gas).

After the part of the SiN film as the first film is oxidized, the valve 243c is closed to stop the supply of the first oxidizing gas into the process chamber 201. Then, the gases and the like remaining in the process chamber 201 are removed from the process chamber 201 by the same processing procedure as the purge in step A1 (purge).

Examples of the first oxidizing gas, which is the first oxidizing agent, may include: an O-containing gas such as oxygen (O) gas, water vapor (H₂O gas), hydrogen peroxide (H₂O₂) gas, nitrous oxide (N₂O) gas, nitrogen monoxide (NO) gas, nitrogen dioxide (NO₂) gas, carbon monoxide (CO) gas, carbon dioxide (CO₂) gas or the like; an O- and H-containing gas; an O- and N-containing gas; and an O- and C-containing gas. One or more of these gases may be used as the first oxidizing gas. As the first oxidizing agent (first oxidizing gas), it is preferably to use an oxidizing agent having (demonstrating) an oxidizing power lower than that of the second oxidizing agents (the second oxidizing gas and the reducing gas) under the same conditions. As the first oxidizing agent (first oxidizing gas), it is more preferable to use the O- and H-containing gas among the above-mentioned gas species. By using the O- and H-containing gas as the first oxidizing agent (first oxidizing gas), for example, the N-H bonds contained in the SiN film as the first film can be efficiently replaced with O-H bonds. As a result, the O-added SiN film can be efficiently caused to contain O-bonds, and the reaction in step C described later can be efficiently caused to occur.

If the processing temperature in step B is lower than the room temperature (25 degrees C), it becomes difficult to partially oxidize the SiN film as the first film by the first oxidizing gas, and it becomes difficult to add O to the SiN film. By setting the processing temperature to the room temperature (25 degrees C) or higher, the oxidation of a portion of the SiN film by the first oxidizing gas can be sufficiently advanced, and O can be added to the SiN film. By setting the processing temperature to 350 degrees C or higher, a practical oxidation rate can be obtained when a part of the SiN film is oxidized using the first oxidizing gas.

In addition, if the processing temperature in step B exceeds 500 degrees C, it may affect the film and structure existing on the surface of the wafer 200 when performing step B. Especially, this may not be permitted in the state-of-the-art devices with temperature restrictions. By setting the processing temperature to 500 degrees C or less, it is possible to suppress this effect. By setting the processing temperature to 450 degrees C or lower, it is possible to sufficiently suppress this effect.

### (Step C)

After step B is finished, a second oxidizing gas and a reducing gas as second oxidizing agents are supplied to the wafer 200 in the process chamber 201, i.e., the O-added SiN film on the wafer 200.

Specifically, the valves 243e and 243d are opened to allow a second oxidizing gas and a reducing gas to flow into the gas supply pipes 232e and 232d, respectively. The flow rates of the second oxidizing gas and the reducing gas flowing through the gas supply pipes 232e and 232d are adjusted by the MFCs 241e and 241d, respectively. The second oxidizing gas and the reducing gas are supplied into the process chamber 201 via the nozzles 249b and 249a. The second oxidizing gas and the reducing gas are mixed and reacted in the process chamber 201, and then exhausted from the exhaust port 231a. At this time, a moisture (H₂O)-free oxidizing species containing O such as atomic oxygen generated by the reaction between the second oxidizing gas and the reducing gas is supplied from the lateral side of the wafer 200 to the wafer 200 (second oxidizing gas + reducing gas supply). At this time, the valves 243f to 243h may be opened to supply an inert gas into the process chamber 201 through the nozzles 249a to 249c, respectively.

Processing conditions when supplying the second oxidizing gas and the reducing gas in step C are exemplified as follows.
Processing temperature: 350 to 500 degrees C, preferably 400 to 450 degrees C
Processing pressure: 10 to 400 Pa, preferably 10 to 133 Pa
Second oxidizing gas supply flow rate: 1 to 10 slm, preferably 1 to 5 slm
Reducing gas supply flow rate: 1 to 10 slm, preferably 1 to 5 slm
Each gas supply time: 60 seconds to 48 hours, preferably 60 seconds to 12 hours
Inert gas supply flow rate (in each gas supply pipe): 0 to 20 slm

By simultaneously supplying the second oxidizing gas and the reducing gas to the wafer 200 under the above-mentioned processing conditions, the O-added SiN film formed on the wafer 200 can be oxidized by utilizing the strong oxidizing power of the oxidizing species such as atomic oxygen generated by the reaction of these gases. At this time, it is possible to further draw O into the O-added SiN film. Further, N contained in the O-added SiN film can be desorbed from the SiN film. As a result, the O-added SiN film can be changed into an oxide film as a second film, i.e., a silicon oxide film (SiO film). That is, the O-added SiN film can be oxidized in a saturated manner and changed into a SiO film. As a result, as shown in FIG. 4C, the O-added SiN film formed on the wafer 200 in step B can be changed to a SiO film.

In order to oxidize the O-added SiN film in a saturated manner, the oxidation of the O-added SiN film in step C by the second oxidizing agents (the second oxidizing gas and the reducing gas) is preferably performed under a high oxidizing power condition than the oxidation of a part of the SiN film in step B by the first oxidizing agent (first oxidizing gas). By oxidizing the O-added SiN film in a saturated manner, reactions such as further addition of O to the O-added SiN film and desorption of N from the O-added SiN film can be caused to occur over the entire thickness of the O-added SiN film. For example, it is possible to reliably oxidize the interface between the SiO film formed on the wafer 200 and the underlying layer of the SiO film, thereby suppressing the residual N in the vicinity of this interface. As a result, the SiO film obtained by oxidizing the O-added SiN film can be a highly pure and dense SiO film containing little or no N.

After the O-added SiN film is oxidized and changed to the SiO film, the valves 243e and 243d are closed to stop the supply of the second oxidizing gas and the reducing gas into the process chamber 201. Then, the gases and the like remaining in the process chamber 201 are removed from the process chamber 201 by the same processing procedure as the purge in step A1 (purge).

As the second oxidizing gas, which is one of the second oxidizing agents, for example, an O-containing gas such as oxygen (O₂) gas, ozone (O₃) gas or the like may be used. One or more of these gases may be used as the second oxidizing gas. As the reducing gas, which is one of the second oxidizing agents, for example, a hydrogen (H)-containing gas such as hydrogen (H₂) gas, deuterium (²H₂) gas or the like, a deuterium (²H)-containing gas, etc. may be used. One or more of these gases may be used as the reducing gas. As the second oxidizing agents (second oxidizing gas and the reducing gas), it is preferable to use an oxidizing agent having (demonstrating) an oxidizing power higher than that of the first oxidizing agent (first oxidizing gas) under the same conditions. The reducing gas alone may not have an oxidizing action. Under certain conditions, the reducing gas reacts with the second oxidizing gas to generate an oxidizing species such atomic oxygen or the like, and acts to improve the efficiency of the oxidation process.

If the processing temperature in step C is less than 350 degrees C, it may become difficult to oxidize the O-added SiN film by the second oxidizing agents (the second oxidizing gas and the reducing gas), and it may become difficult to change the O-added SiN film into the SiO film. By setting the processing temperature to 350 degrees C or higher, the oxidation of the O-added SiN film by the second oxidizing agents (the second oxidizing gas and the reducing gas) can be sufficiently performed, and the O-added SiN film can be sufficiently changed into the SiO film. By setting the processing temperature to 400 degrees C or higher, a practical oxidation rate can be obtained when the O-added SiN film is oxidized using the second oxidizing agents (the second oxidizing gas and the, reducing gas).

In addition, if the processing temperature in step C exceeds 500 degrees C, it may affect the film and structure existing on the surface of the wafer 200 when performing step C. Especially, this may not be permitted in the state-of-the-art devices with temperature restrictions. By setting the processing temperature to 500 degrees C or less, it is possible to suppress this effect. By setting the processing temperature to 450 degrees C or lower, it is possible to sufficiently suppress this effect.

It has been found that at the low temperature described above, if a SiN film having a poor film quality (a SiN film containing many N-H bonds and impurities) is formed in step A, a SiO film having a good film quality can be obtained in step C. For this reason, the processing temperature in step A is preferably set to be lower than or equal to the processing temperature in step C. More preferably, the processing temperature in step A is set to be lower than the processing temperature in step C. Further, in order to further improve the film quality of the SiO film obtained in step C, it is necessary to perform the oxidation of a part of the SiN film in step B in an unsaturated manner and to perform the oxidation of the O-added SiN film in step C in a saturated manner. For this reason, it is preferable that the processing temperature in step B is equal to or lower than the processing temperature in step C, and it is more preferable that the processing temperature in step B is lower than the processing temperature in step C. Further, in order to further increase the degree of unsaturation of the oxidation of the part of the SiN film in step B, it is preferable that the processing temperature in step B is equal to or lower than the processing temperature in step A, and it is more preferable that the processing temperature in step B is lower than the processing temperature in step A.

### (After-Purging and Returning to Atmospheric Pressure)

After step C is finished, an inert gas as a purge gas is supplied into the process chamber 201 from each of the nozzles 249a to 249c and is exhausted from the exhaust port 231a. As a result, the inside of the process chamber 201 is purged, and the gas, reaction by-products and the like remaining in the process chamber 201 are removed from the inside of the process chamber 201 (after-purging). Thereafter, the atmosphere in the process chamber 201 is replaced with the inert gas (inert gas replacement), and the pressure in the process chamber 201 is returned to the atmospheric pressure (returning to atmospheric pressure).

### (Boat Unloading and Wafer Discharging)

Thereafter, the seal cap 219 is lowered by the boat elevator 115 to open the lower end of the manifold 209. Then, the processed wafers 200 supported by the boat 217 are unloaded from the lower end of the manifold 209 to the outside of the reaction tube 203 (boat unloading). After the boat is unloaded, the shutter 219s is moved and the lower end opening of the manifold 209 is sealed by the shutter 219s via the O-ring 220c (shutter closing). The processed wafers 200 are discharged out of the boat 217 after being unloaded from the reaction tube 203 (wafer discharging).

Steps A, B and C are preferably performed in the same process chamber (in-situ). Accordingly, steps A, B and C can be performed without exposing the wafer 200 to the atmosphere, that is, while the surface of the wafer 200 is kept clean, and a high-quality SiO film can be formed at a low temperature with good controllability.

### (3) Effects of the Present Embodiment

According to the present embodiment, one or more of the following effects may be obtained.

By forming the SiN film as the first film in step A, adding O to the SiN film in step B, and changing the O-added SiN film to the SiO film as the second film in step C, a high-quality SiO film can be formed at a low temperature. That is, by modifying the SiN film as the first film in multiple steps in this way and changing the SiN film to the SiO film as the second film, it becomes possible to form a film with high etching resistance, i.e., a film with high processing resistance, i.e., a film with high quality at a low temperature.

By forming the SiN film as the first film in step A, adding O to the SiN film in step B, and changing the O-added SiN film to the SiO film as the second film in step C, a high-quality SiO film can be formed at a low temperature with high productivity. That is, by modifying the SiN film as the first film in multiple steps in this way and changing the SiN film to the SiO film as the second film, it becomes possible to form a high-quality film at a low temperature with high productivity.

The present inventors have confirmed that if the SiN film is modified in one step rather than in multiple steps at the low temperature as in the present embodiment, the SiN film cannot be sufficiently oxidized and the SiN film cannot be changed to the SiO film. In addition, the present inventors have confirmed that when attempting to modify the SiN film in one step rather than in multiple steps, it may take a long time to fully oxidize the SiN film.

On the other hand, the present inventors have found that at the low temperature as in the present embodiment, by modifying the SiN film in multiple steps in such a way that first, O is added to the SiN film by softly oxidizing the SiN film (in an unsaturated manner) under the low oxidizing power condition and then strongly oxidizing the O-added SiN film O (in a saturated manner) under the high oxidizing power condition, it is possible to sufficiently oxidize the SiN film with high throughput and change the SiN film to the SiO film. In addition, the present inventors have found that the multi-step modification, i.e., the multi-step oxidation makes it possible to form a film with high etching resistance, i.e., a film with high processing resistance, i.e., a film with high quality at a low temperature.

By forming the SiN film as the first film in step A, adding O to the SiN film in step B, and changing the O-added SiN film to the SiO film as the second film in step C, it is possible to form a SiO film with a high purity and a high insulating property at a low temperature. That is, by modifying the SiN film as the first film in multiple steps in this way and changing the SiN film to the SiO film as the second film, it is possible to obtain a high-purity and high-insulating-property SiN film containing little or no N at a low temperature. Further, it is possible to reliably oxidize the interface between the SiO film formed on the wafer 200 and the underlying layer of the SiO film, thereby suppressing residual N in the vicinity of the interface. As a result, the SiO film obtained by oxidizing the O-added SiN can be a highly pure and dense SiO film containing little or no N.

### (4) Modification

The substrate processing sequence according to the present embodiment may be modified as in the modifications described below. These modifications may be combined arbitrarily. Unless otherwise specified, the processing procedures and processing conditions in each step of each modification may be the same as the processing procedures and processing conditions in each step of the substrate processing sequence described above.

### (Modification 1)

As in the processing sequence indicated below, a cycle including steps A, B and C may be performed a predetermined number of times (n times where n is an integer of 1 or more), and may be repeated multiple times (n times where n is an integer of 2 or more). The case in which this cycle is performed once (the case where n=1) corresponds to the above-described embodiment.

[(precursor → reactant) × m → first oxidizing gas → second oxidizing gas + reducing gas] × n

When the cycle including step A, step B and step C is performed multiple times (n times where n is an integer of 2 or more), the first cycle performs steps A to C in the same manner as in the above-described embodiment to form a SiO film on the wafer 200 as shown in FIGS. 5A to 5C. Specifically, in step A of the first cycle, as shown in FIG. 4A, a SiN film as a first film is formed on the wafer 200. In step B of the first cycle, as shown in FIG. 4B, a part of the SiN film formed on the wafer 200 is oxidized to change the SiN film into an O-added SiN film (O doped SiN). In step C of the first cycle, as shown in FIG. 4C, the O-doped SiN film formed on the wafer 200 is oxidized and changed into a SiO film as a second film.

When the cycle including step A, step B and step C is performed multiple times (n times where n is an integer of 2 or more), the cycle of the second time performs steps A to C to form a SiO film on the SiO film formed on the wafer 200 in the cycle of the first time, as shown in FIGS. 5D to 5F. Specifically, in step A of the second cycle, as shown in FIG. 5D, a SiN film as a first film is formed on the SiO film as the second film formed on the wafer 200 in the first cycle. In step B of the second cycle, as shown in FIG. 5E, a part of the SiN film formed on the SiO film is oxidized to change the SiN film into an O-added SiN film (O-doped SiN). In step C of the second cycle, as shown in FIG. 5F, the O-doped SiN film formed on the SiO film is oxidized to change the O-doped SiN film into a SiO film as a second film.

As a result, a SiO film can be formed on the wafer 200 by stacking SiO films obtained by modifying the SiN film in multiple steps. Although FIGS. 5A to 5F show an example in which the cycle including steps A, B and C is performed twice, this cycle may be repeated three times or more.

Also in this modification, the same effects as those of the above-described embodiment can be obtained. Moreover, according to this modification, the SiN film formed per cycle can be made thinner than in the above-described embodiment, and the effect of modifying the SiN film in multiple steps can be further enhanced. This makes it possible to form a high-quality film having a higher etching resistance, i.e., processing resistance, at a low temperature. In addition, it becomes possible to form a SiO film having a higher purity and a higher insulating property. Further, by repeating the process of oxidizing the thin SiN film in multiple steps a plurality of times, it is possible to relax the internal stress of the formed SiO film and to reduce the film stress of the finally-formed SiO film. This makes it possible to suppress deformation of the uneven structure such as pillars and the like formed on the surface of the wafer 200.

### (Modification 2)

As in the processing sequence indicated below, a cycle that includes a step of performing a set including steps A and B a predetermined number of times (n₁ times where n₁ is an integer of 1 or more), and step C may be performed a predetermined number of times (n₂ times where n₂ is an integer of 1 or more). In this case, the set including step A and step B may be performed multiple times (n₁ times where n₁ is an integer of 2 or more). In addition, a cycle that includes a step of performing a set including steps A and B a predetermined number of times (n₁ times where n₁ is an integer of 1 or more), and step C may be performed multiple times (n₂ times where n₂ is an integer of 2 or more). The case where n₁ = 1 and n₂ = 1 corresponds to the above-described embodiment, and the case where n₁ = 1 corresponds to Modification 1 described above.

[[(precursor → reactant) × m → first oxidizing gas] × n₁ → second oxidizing gas + reducing gas] × n₂

When step C is performed after performing a set including step A and step B multiple times (n₁ times where n₁ is an integer of 2 or more), in step A of the first set, as shown in FIG. 6A, a SiN film is formed as a first film on the wafer 200. In step B of the first set, as shown in FIG. 6B, a part of the SiN film formed on the wafer 200 is oxidized to change the SiN film into an O-added SiN film. In step A of the second set, as shown in FIG. 6C, a SiN film is formed as a first film on the O-added SiN film. In step B of the second set, as shown in FIG. 6D, a part of the SiN film formed on the O-added SiN film is oxidized to change the SiN film into an O-added SiN film. As shown in FIG. 6D, in this state, the O-added SiN films are stacked on the wafer 200. Thereafter, in step C, as shown in FIG. 6E, the O-added SiN film stacked on the wafer 200 is oxidized to change the O-added SiN film into a SiO film as a second film.

This makes it possible to form a SiO film on the wafer 200 by oxidizing the stacked O-added SiN films. FIGS. 6A to 6E show the example in which the cycle that includes a step of performing a set including step A and step B twice, and step C is performed once. However, the set may be repeated three or more times, and the cycle may be repeated twice or more times.

Also in this modification, the same effects as in the above-described embodiment can be obtained. In addition, according to this modification, the SiN film formed per set can be made thinner than that of the above-described embodiment, and the effect of softly oxidizing the SiN film (in an unsaturated manner) under the low oxidizing power condition can be spread uniformly over the entire SiN film. Thus, the effect of strongly oxidizing the O-added SiN film (in a saturated manner) under the high oxidizing power condition can be effectively and efficiently applied to all the stacked O-added SiN films. As a result, it is possible to form a high-quality film with a higher etching resistance, i.e., processing resistance, at a low temperature with higher productivity.

### (Modification 3)

As in the processing sequence indicated below, m may be set to be 1 in modification 2. That is, in step A in modification 2, the step A1 of supplying the precursor to the wafer 200 and the step A2 of supplying the reactant to the wafer 200 may be alternately performed once.

[(precursor → reactant → first oxidizing gas) × n₁ → second oxidizing gas + reducing gas] × n₂

Also in this modified example, the same effects as in the above-described modification 2 may be obtained. In addition, according to this modification, the SiN film formed per set can be made thinner than that of the above-described modification 2, and the effect of softly oxidizing the SiN film (in an unsaturated manner) under the low oxidizing power condition can be spread uniformly over the entire SiN film. Moreover, the processing time in steps A and B can be shortened just as much as the SiN film formed per set is made thin. Thus, the effect of strongly oxidizing the O-added SiN film (in a saturated manner) under the high oxidizing power condition can be effectively and efficiently applied to all the stacked O-added SiN films. As a result, it is possible to form a high-quality film with a higher etching resistance, i.e., processing resistance, at a low temperature with higher productivity.

### (Modification 4)

In modification 1 or modification 2, the thickness of the SiN film formed in the first cycle may be made thinner than the thickness of the SiN film formed in each of the second and subsequent cycles.

According to this modification, when forming the SiO film in the first cycle, it is possible to promote the oxidation of the SiN film and the O-added SiN film. Thus, it is possible to effectively suppress residual N in the vicinity of the interface between the SiO film formed on the wafer 200 and the underlying layer of the SiO film, and it is possible to promoting the cleaning of the interface. For example, it is possible to optimize the interface by reducing defects at the interface and reducing leak paths. As a result, it is possible to reduce a leakage current.

### (Modification 5)

In step A, a silane-based gas containing C, such as an alkylene chlorosilane-based gas or an alkyl chlorosilane-based gas, may be used as the precursor. Further, a reactant containing C, such as an amine-based gas or an organic hydrazine-based gas may be used as the reactant. In this case, in step A, a silicon carbonitride film (SiCN film) may be formed on the wafer 200. In step B, a part of the SiCN film may be oxidized to change the SiCN film into an O-added SiCN film. In step C, the O-doped SiCN film may be oxidized and changed to a SiO film.

In step C, it becomes possible to further draw O into the O-added SiCN film. In addition, C and N contained in the O-added SiCN film can be desorbed from the film. As a result, the O-added SiCN film can be changed to a SiO film. That is, the O-added SiCN film can be oxidized in a saturated manner and changed into a SiO film. Also in this modification, the same effects as in the above-described embodiment may be obtained.

### (Modification 6)

As in the processing sequence indicated below, in step A, various types of precursors (precursor gases) with different molecular structures may be used. The following processing sequence shows an example using two types of precursors, i.e., a first precursor (first raw material gas) and a second precursor (second precursor gas) having a different molecular structure from the first precursor.

(first precursor → second precursor → reactant) × m → first oxidizing gas → second oxidizing gas + reducing gas

It is preferable that a silane-based gas containing one Si per molecule is used as the first precursor, and a silane-based gas containing at least two Si per molecule is used as the second precursor. More preferably, the second precursor may have S-S bonds. It is preferable that the first precursor is more difficult to thermally decompose than the second precursor under the same conditions. That is, it is preferable that the first precursor may have lower reactivity and less adsorption than the second precursor under the same conditions.

Also in this modification, the same effects as in the above-described embodiment may be obtained. Further, according to this modification, it is possible to improve the step coverage characteristic of the SiN film formed on the wafer 200, i.e., the SiO film obtained by oxidizing the SiN film in multiple steps. This effect can be sufficiently obtained by setting the supply time of the first precursor to be equal to or longer than the supply time of the second precursor. Further, this effect can be obtained more sufficiently by setting the supply time of the first precursor to be longer than the supply time of the second precursor. In addition, by using two types of precursors, the cycle rate (the thickness of the SiN layer formed per cycle) can be increased as compared with the case where one type of precursor is used, thereby improving the productivity.

### <Other Embodiments of the Present Disclosure>

The embodiment of the present disclosure has been specifically described above. However, the present disclosure is not limited to the above-described embodiment, and various changes may be made without departing from the gist thereof.

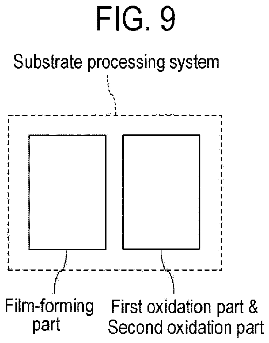

For example, in the above-described embodiment, the example in which step A, step B and step C are performed within the same process chamber 201 (in-situ) has been described. However, at least one of step A, step B and step C may be performed in a different process chamber (ex-situ), i.e., in a different processing part (processing space). For example, step A, step B and step C may be performed in the film-forming part, the first oxidation part and the second oxidation part, respectively, in the substrate processing system shown in FIG. 7. Alternatively, step A and step B may be performed in the film-forming part and the first oxidation part of the substrate processing system shown in FIG. 8, and step C may be performed in the second oxidation part. Alternatively, step A may be performed in the film-forming part of the substrate processing system shown in FIG. 9, and steps B and C may be performed in the first and second oxidation parts. Each part may be a stand-alone-type substrate processing apparatus, or may be each process chamber of a cluster type substrate processing apparatus. It can be said that the substrate processing apparatus shown in FIG. 1 in the above-described embodiment is a substrate processing system in which the film-forming part, the first oxidation part and the second oxidation part are the same (shared). If at least one of step A, step B and step C is performed in a separate processing chamber, the temperature in each process chamber can be preset to, for example, the processing temperature in each step or a temperature close thereto. This makes it possible to shorten the time required for temperature regulation and improve the production efficiency.

Further, for example, in the above-described embodiment and modifications, there has been described the example in which the first element constituting the first film and the second film includes Si which is a semiconductor element. However, the first element may include a metal element. Examples of the metal element may include aluminum (Al), titanium (Ti), hafnium (Hf), zirconium (Zr), tantalum (Ta), molybdenum (Mo), tungsten (W), and the like.

Further, for example, in the above-described embodiment and modifications, there has been described the example in which the SiN film or the SiCN film is formed as the first film, and the SiO film is formed as the second film. However, a metal nitride film or a metal carbonitride film may be formed as the first film, and a metal oxide film may be formed as the second film. Examples of the metal nitride film and the metal carbonitride film may include an aluminum nitride film (AlN film), an aluminum carbonitride film (AlCN film), a titanium nitride film (TiN film), a titanium carbonitride film (TiCN film), a hafnium nitride film (HfN film), a hafnium carbonitride film (HfCN film), a zirconium nitride film (ZrN film), a zirconium carbonitride film (ZrCN film), a tantalum nitride film (TaN film), a tantalum carbonitride film (TaCN film), a molybdenum nitride film (MoN), a molybdenum carbonitride film (MoCN), a tungsten nitride film (WN), a tungsten carbonitride film (WCN), and the like. Examples of the metal oxide film may include an aluminum oxide film (AlO film), a titanium oxide film (TiO film), a hafnium oxide film (HfO film), a zirconium oxide film (ZrO film), a tantalum oxide film (TaO film), a molybdenum oxide film (MoO), a tungsten oxide film (WO), and the like.

It is preferable that the recipe used for each process is prepared separately according to the processing contents and are stored in the memory 121c via an electric communication line or an external memory 123. When starting each process, it is preferable that the CPU 121a properly selects an appropriate recipe from a plurality of recipes stored in the memory 121c according to the contents of the process. This makes it possible to form films of various film types, composition ratios, film qualities and film thicknesses with high reproducibility in one substrate processing apparatus. In addition, the burden on an operator can be reduced, and each process can be quickly started while avoiding operation errors.

The above-described recipes are not limited to the newly prepared ones, but may be prepared by, for example, changing the existing recipes already installed in the substrate processing apparatus. In the case of changing the recipes, the recipes after the change may be installed in the substrate processing apparatus via an electric communication line or a recording medium in which the recipes are recorded. In addition, the input/output device 122 provided in the existing substrate processing apparatus may be operated to directly change the existing recipes already installed in the substrate processing apparatus.

In the above-described embodiment, there has been described an example in which a film is formed using a batch type substrate processing apparatus for processing a plurality of substrates at a time. The present disclosure is not limited to the above-described embodiment, but may be suitably applied to, for example, a case where a film is formed using a single-wafer type substrate processing apparatus for processing one or several substrates at a time. Furthermore, in the above-described embodiment, there has been described an example in which a film is formed using a substrate processing apparatus having a hot wall type process furnace. The present disclosure is not limited to the above-described embodiment but may also be suitably applied to a case where a film is formed using a substrate processing apparatus having a cold wall type process furnace.

Even when these substrate processing apparatuses are used, each process can be performed under the same processing procedures and processing conditions as those of the above-described embodiment and modifications. Effects similar to those of the above-described embodiment and modifications may be obtained.

The above-described embodiments and modifications may be used in combination as appropriate. The processing procedure and processing conditions at this time may be, for example, the same as the processing procedures and processing conditions of the above-described embodiment and modifications.

### [Embodiment Example]

### <Embodiment Example 1>

An evaluation sample 1 of Embodiment Example 1 was manufactured by processing a wafer according to the processing sequence of the above-described embodiment, i.e., according to the processing sequence in which step A, step B and step C are performed in the named order. The processing conditions in each step when manufacturing evaluation sample 1 were set to predetermined conditions within the range of the processing conditions in each step described above. The processing temperature in step A was 350 degrees C, the processing temperature in step B was the room temperature, and the processing temperature in step C was 450 degrees C. The substances exemplified in the above-described embodiments were used as the film-forming agent, the first oxidizing agent and the second oxidizing agents.

### <Embodiment Example 2>

An evaluation sample 2 of Embodiment Example 2 was manufactured by processing a wafer according to the processing sequence of the above-described embodiment, i.e., according to the processing sequence in which step A, step B and step C are performed in the named order. The processing conditions in each step when manufacturing evaluation sample 2 were set to predetermined conditions within the range of the processing conditions in each step described above. The processing temperature in step A was 450 degrees C, the processing temperature in step B was the room temperature, and the processing temperature in step C was 450 degrees C. The substances exemplified in the above-described embodiment were used as the film-forming agent, the first oxidizing agent and the second oxidizing agents.

### <Comparative Example 1>

Evaluation sample 3 of Comparative Example 1 was manufactured by processing a wafer according to a processing sequence in which step B is omitted from the processing sequence of the above-described embodiment and step A and step C are performed in the named order. The processing conditions in steps A and C when manufacturing evaluation sample 3 were the same as the processing conditions in steps A and C when manufacturing evaluation sample 1. The substances exemplified in the above-described embodiment were used as the film-forming agent and the second oxidizing agents.

After manufacturing the respective evaluation samples, the film type of the film formed on the wafer of each evaluation sample was confirmed. When the film type is a SiO film, the atomic concentrations of Si and O in the SiO film and the wet etching rate (WER) of the SiO film were measured. The WER was measured by subjecting the obtained SiO film to wet etching with a 0.1% concentration HF aqueous solution.

As a result, it was confirmed that a SiO film was formed on the wafer in evaluation sample 1. The Si atomic concentration of the SiO film in evaluation sample 1 was 33.2 at %, and the O atomic concentration thereof was 66.3 at %. The WER of the SiO film in evaluation sample 1 was 80 A/min, which confirms that a high etching resistance is obtained. Moreover, it was confirmed that a SiO film was formed on the wafer in evaluation sample 2. The Si atomic concentration of the SiO film in evaluation sample 2 was 32.9 at %, and the O atomic concentration thereof was 65.8 at %. The WER of the SiO film in evaluation sample 2 was 69 A/min, which confirms that a high etching resistance is obtained. On the other hand, it was confirmed that a SiN film is formed on the wafer in evaluation sample 3, and a SiO film is not formed. For these reasons, at the low temperature described above, it is difficult to oxidize the first film if step B is omitted and thus, it was found that step B acts as a trigger for changing the first film into the second film.

According to the present disclosure in some embodiments, it is possible to improve the film quality of an oxide film formed on a substrate.

While certain embodiments have been described, these embodiments have been presented by way of example only, and are not intended to limit the scope of the disclosures. Indeed, the embodiments described herein may be embodied in a variety of other forms. Furthermore, various omissions, substitutions, and changes in the form of the embodiments described herein may be made without departing from the disclosures. The accompanying claims and their equivalents are intended to cover such forms or modifications as would fall within the scope of the disclosures.

## Claims

1. A method of processing a substrate comprising:
(a) forming a first film on the substrate by supplying a film-forming agent to the substrate;
(b) adding oxygen to the first film by supplying a first oxidizing agent to the substrate and oxidizing a part of the first film; and
(c) changing the oxygen-added first film into a second film including an oxide film by supplying a second oxidizing agent to the substrate and oxidizing the oxygen-added first film.

2. The method of Claim 1, wherein the oxidation of the part of the first film by the first oxidizing agent in (b) is performed under a lower oxidizing power condition than the oxidation of the oxygen-added first film by the second oxidizing agent in (c).

3. The method of Claim 1, wherein in (b), the first film is oxidized in an unsaturated manner, and in (c), the oxygen-added first film is oxidized in a saturated manner.

4. The method of Claim 1, wherein an oxidizing agent, whose oxidizing power is lower than a oxidizing power of the second oxidizing agent under the same condition, is used as the first oxidizing agent.

5. The method of Claim 1, wherein the first oxidizing agent includes a first oxidizing gas, and the second oxidizing agent includes a second oxidizing gas and a reducing gas.

6. The method of Claim 5, wherein the first oxidizing gas includes at least one selected from the group of O₂ gas, H₂O gas, H₂O₂ gas, N₂O gas, NO gas, NO₂ gas, CO gas and CO₂ gas,
the second oxidizing gas includes at least one selected from the group of O₂ gas and O₃ gas, and
the reducing gas includes at least one selected from the group of H₂ gas and ²H₂ gas.

7. The method of Claim 1, wherein the first film contains a first element and a second element, and the second film contains the first element and oxygen.

8. The method of Claim 7, wherein the first element includes a metal element or a semiconductor element, and the second element includes nitrogen.

9. The method of Claim 7, wherein the film-forming agent includes a precursor containing the first element and a halogen element, and a reactant containing the second element, and
in (a), supplying the precursor to the substrate and supplying the reactant to the substrate are alternately performed.

10. The method of Claim 1, wherein a temperature of the substrate in (a) is equal to or lower than a temperature of the substrate in (c).

11. The method of Claim 1, wherein a cycle including (a), (b), and (c) is performed multiple times.

12. The method of Claim 1, wherein a cycle that includes performing a set including (a) and (b) multiple times and performing (c) is performed a predetermined number of times.

13. A method of manufacturing a semiconductor device, comprising:
(a) forming a first film on a substrate by supplying a film-forming agent to the substrate;
(b) adding oxygen to the first film by supplying a first oxidizing agent to the substrate and oxidizing a part of the first film; and
(c) changing the oxygen-added first film into a second film including an oxide film by supplying a second oxidizing agent to the substrate and oxidizing the oxygen-added first film.

14. A substrate processing system, comprising:
a film-forming part configured to form a first film on a substrate by supplying a film-forming agent to the substrate;
a first oxidation part configured to add oxygen to the first film by supplying a first oxidizing agent to the substrate and oxidizing a part of the first film; and
a second oxidation part configured to change the oxygen-added first film into a second film including an oxide film by supplying a second oxidizing agent to the substrate and oxidizing the oxygen-added first film.

15. A program that causes, by a computer, a substrate processing system to perform:
(a) forming a first film on a substrate by supplying a film-forming agent to the substrate;
(b) adding oxygen to the first film by supplying a first oxidizing agent to the substrate and oxidizing a part of the first film; and
(c) changing the oxygen-added first film into a second film including an oxide film by supplying a second oxidizing agent to the substrate and oxidizing the oxygen-added first film.
